(19) Europäisches Patentamt
European Patent Office
Office européen des brevets

(11) EP 0 740 208 A1

(12) # EUROPEAN PATENT APPLICATION

(43) Date of publication:
30.10.1996 Bulletin 1996/44

(51) Int. Cl.[6]: **G03F 3/10**, G03F 7/027, G03F 7/033, G03F 7/038

(21) Application number: 96104277.7

(22) Date of filing: 18.03.1996

(84) Designated Contracting States:
BE DE FR GB IT NL

(30) Priority: 27.04.1995 US 429936

(71) Applicant: MINNESOTA MINING AND MANUFACTURING COMPANY
St. Paul, Minnesota 55133-3427 (US)

(72) Inventor: Elmasry, Mohamed A.,
c/o Minnesota Mining and
Saint Paul, Minnesota 55133-3427 (US)

(74) Representative: Allaix, Roberto, Dr. et al
3M Italia S.p.A.,
Intellectual Property Department,
Via Martiri della Libertà 57
17016 Ferrania (Savona) (IT)

(54) **Aqueous developable color proofing elements**

(57) The incorporation of an alkyl vinyl- or aryl vinyl-maleic anhydride partial-ester copolymer having a plurality of ethylenically unsaturated groups in the color photosensitive layer of negative acting overlay and single sheet color proofing elements are described. The color proofing elements show improved exposure speed and highlight dot retention. In addition, the photosensitive color layer shows no inhibition to oxygen.

EP 0 740 208 A1

## Description

### Field of the Invention

This invention relates to aqueous developable pre-sensitized color proofing elements. In particular, this invention relates to color proofing constructions having incorporated into the photosensitive color layer an alkyl vinyl or aryl vinyl maleic anhydride partial-ester copolymer having pendant ethylenically unsaturated groups giving rise to improved halftone dot reproduction.

### Discussion of the Art

In color reproduction, the color accuracy of graphic art color separation negatives are generally verified using color proofing systems prior to making the corresponding printing plates. The color proofing systems must provide a consistent representation of the final color print. It is well known in the art that the halftone dot retention plays a significant role in the color rendition of the final image. Slight changes in the dot reproduction curve can cause significant changes in visual color perception.

Several different types of color proofing systems are well known in the literature. Both digital and conventional proofing systems are available commercially. In digital systems, digitized data is used to directly image the color proofing materials. However, conventional proofing systems are primarily used when verifying the color accuracy of graphic art color separation films. Conventional color proofing systems consist of two types: overlay and surprint.

Overlay systems provide a convenient and quick way to visualize a representative color on a transparent substrate. A typical overlay film construction includes a polyester substrate and photosensitive color layer. Optional protective layers may also be included over the surface of the photosensitive color layer. A color proof is constructed by individually imaging and developing each representative color proofing film. The color imaged films are then laid upon each other in register on a paper stock. Even though this method provides a very simple way of combining two or more colors in registration, it has several inherent disadvantages. The multiplicity of plastic sheets cause incident light to internally reflect which imparts a gloss, color hue shift and a distortion of the final image. Antireflection coatings improve the visual perception of the proof; however, the presence of the thick polyester between each colored image still causes visual distortion of the final image. Examples of these types of constructions may be generally found in U.S. Patent Nos. 3,136,637; 4,304,836; 4,482,625; 4,634,652; 4,748,101; 4,952,482; and 5,258,261.

A surprint proof is generated by successively superimposing different colored layers upon each other on a single sheet. The surprint color proofing materials are composed of two primary types: photosensitive precolored sheets and photosensitive colorless sheets whose latent image may be toned with pigments, inks or dyes. Some examples of post-colored proofing materials may be found in U.S. Patent Nos. 3,060,024; 3,634,087; and DE 3,336,431. In the photopolymer systems the image is generally weak and often requires a protective layer. The resultant color hue is also very user dependent due to the dependency upon color density control, lot to lot variation of the colorants and dusting of the toners causing color contamination. The electrostatic systems require more sophisticated equipment and environmental control which can be very expensive.

Another example of a precolored proofing system includes photosensitive constructions that are imaged prior to lamination to the receptor or intermediate sheet. Representative examples of these types of systems are described in U.S. Patent Nos. 4,482,625 and 4,304,836. These systems require the imaged films to be laminated in register which is dependent upon laminating speed and temperature, and dimensional stability of the film and receptor. The accuracy of the registration is limited to smaller format proofs due to the difficulty in retaining perfect alignment of images during the thermal lamination process. Even though the exposure times may be shorter in these systems, productivity is lost due to the difficulties in producing several small proofs on a single large sheet known as scatter proofing.

U.S. Patent No. 3,671,236 describes a negative acting presensitized color proofing element comprising a carrier sheet having a smooth release surface, a diazo sensitized color layer and a non-photoactive barrier layer upon which may be coated a pressure sensitive adhesive or a thermal adhesive as described in U.S. Patent No. 4,656,114. The developing media for this system is a 50:50 mixture of n-propanol and water. The barrier layer is present as a carrier for the image and to reduce interaction between the adhesive and the photoactive layer. U.S. Patent Nos. 4,650,738; 4,751,166; 4,808,508; 4,929,532; and 5,008,174; EP 365,356 and EP 365,357 patent applications describe improvements on this construction by eliminating the need for a barrier layer between the diazo based photoactive layer and the adhesive. The developer used in these systems are aqueous alkali solutions containing greater than 3% surfactant.

U.S. Patent No. 4,596,757 discloses a further improvement on the construction described in U.S. Patent No. 3,671,236 by utilizing a photo monomer system in place of the diazonium binders. Again an aqueous alkali developer is used which contains high concentrations of a surfactant (the example cited used 8.5%).

U.S. Patent No. 5,248,583 describes a construction which utilizes a photoactive color layer containing a photo-oligomer as the photopolymerizable component and a photopolymerizable barrier layer to provide a proofing element that can be developed in a low solids aqueous developer having a pH of 10.2. This construction allows one to develop the

image using a more environmentally compatible effluent since the aqueous developer contains less caustic and less ingredients than those used in the previously described systems.

Some attempts have been made to provide an adhesive interface with the photosensitive color layer which has a gradient of solubilities to improve the background staining problem. U.S. Patent Nos. 5,080,996 and 5,008,174 describe a color proofing element and process for making the element where this type of gradient is formed. The gradient of solubilities is formed when the adhesive is coated onto the photosensitive color layer. In this particular application, it is critical that the colorant does not become intermixed with the adhesive.

To achieve a system that is developable in a developing solution having a more neutral pH, the binders used in the photosensitive proofing formulation typically make the image more susceptible to attack by the developer. When the resistively developable image is swelled or attacked by the developer it becomes increasingly more difficult to hold the highlight dots (0.5 - 10% halftone dots) without sacrificing the shadow areas (90 - 99.5% halftone dots). The shadow areas are sacrificed when the photosensitive layer is overexposed to achieve sufficient cross-link density in the highlight dots to resist developer attack. However, when a photosensitive layer is overexposed, the shadow areas begin to fill-in due to halation effects. This over-exposure also increases the overall dot gain, which significantly affects the color rendition. Therefore, there exists a need for a proofing system that maintains highlight halftone dots without over-exposure and is developable in an aqueous developer having low solids and a pH less than 10.5.

## Summary of the Invention

The present invention provides an overlay photosensitive color proofing element comprising: (a) a carrier; and (b) a photosensitive color layer comprising: i) a photopolymerizable oligomer comprising an alkyl vinyl- or aryl vinyl- maleic anhydride partial-ester copolymer having a plurality of pendant ethylenically unsaturated groups, an acid number of 100 to 250, and a number average molecular weight of 1,000 to 20,000, ii) a photopolymerizable compound having a plurality of ethylenically unsaturated pendant polymerizable groups and a weight average molecular weight of 400 to 1,500, iii) a colorant, and iv) a photoinitiator.

Another embodiment provides a negative acting single sheet color proofing element comprising, in order: (a) a releasable carrier; (b) a photosensitive color coating comprising; i) a photopolymerizable oligomer comprising an alkyl vinyl- or aryl vinyl- maleic anhydride partial-ester copolymer having a plurality of pendant ethylenically unsaturated groups, an acid number of 100 to 250 and a number average molecular weight of 1,000 to 20,000, ii) a photopolymerizable compound having a plurality of ethylenically unsaturated pendant polymerizable groups and a weight average molecular weight of 400 to 1,500, iii) a colorant, and iv) a photoinitiator; (c) a photopolymerizable barrier coating; and (d) a thermally activated adhesive.

In yet another embodiment, a negative acting color proofing element is described comprising, in order:

(a) releasable carrier;

(b) a photosensitive color coating comprising:

(i) a photopolymerizable oligomer having the formula;

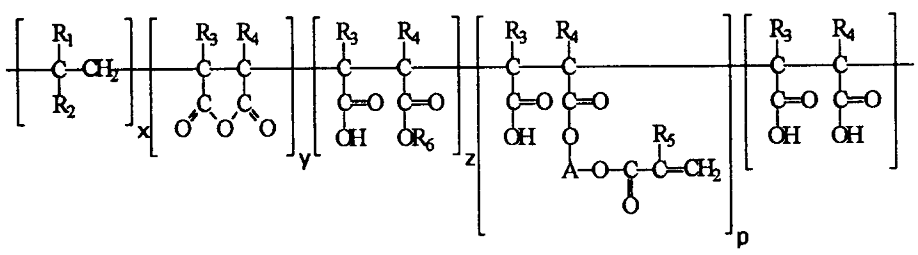

wherein:

$R_1$ and $R_2$ are the same or different groups and are selected from the group consisting essentially of hydrogen, alkyl containing from 1 to 20 carbon atoms, aryl containing from 6 to 10 carbons atoms, alkaryl containing from 7 to 14 carbon atoms, cycloalkyl containing from 4 to 12, and halogen;

$R_3$, $R_4$ and $R_5$ are the same or different groups and are selected from the group consisting of hydrogen and alkyl of from 1 to 5 carbon atoms;

$R_6$ is the same or different group selected from the group consisting of hydrogen, alkyl, aralkyl, and alkyl substituted aralkyl groups containing from 1 to 20 carbon atoms, and oxyalkylated derivatives of such

groups containing from 2 to 4 carbon atoms in each oxyalkylene group, which group may be from 1 to 20 repeating units;

A is a linear or branched divalent alkylene of from 1 to 20 carbon atoms or an oxyalkylated derivative thereof as described in connection with $R_6$;

subscripts x, y, z, m and p are each whole numbers such that the sum of x, y, z, m and p may range from 3 to about 20; x, p and y are each equal to or greater than 1;m may be O; and z may be O;

said oligomer having an acid number of 100 to 250 and a number average molecular weight of at least 1,000, preferably 1,000 to 20,000, more preferably 1,000 to 10,000, and most preferably 1,000 to 5,000;

(ii) a polymerizable compound having a plurality of pendant ethylenically unsaturated polymerizable groups and a weight average molecular weight of 400 to 1,500;
(iii) a colorant; and
(iv) a photoinitiator;

(c) a photopolymerizable barrier coating; and
(d) a thermally activated adhesive.

A multicolored image on a single receptor can be obtained by performing the following steps using the aforesaid single sheet photosensitive color proofing element:

(i) laminating a first color proofing element with heat and pressure via the thermal adhesive to a developer resistant receptor;
(ii) removing the carrier sheet;
(iii) exposing the photosensitive laminated structure through a color separation negative corresponding to the color of the color coating to actinic radiation to crosslink the exposed areas of the photosensitive element and rendering the color and barrier coatings insoluble in an aqueous alkaline developing medium to create a latent image;
(iv) developing the latent image with an aqueous alkaline developing medium whereby unexposed color and barrier coatings are removed and exposed color and barrier coatings remain;
(v) laminating another photosensitive element having a different colorant in the color coating to the developed first photosensitive color proofing element;
(vi) repeating steps (ii)-(iv) with a subsequent separation negative being in register with the developed first photosensitive element; and
(vii) repeating steps (v) and (ii)-(iv) in that order with additional photosensitive elements as described above, each of the photosensitive elements being of a different color or visual texture, to provide a multi-colored image on a single substrate.

It is recognized by one skilled in the art that other procedures can be used to obtain a multi-colored image on a single substrate using the aforesaid photosensitive element in the processes described in U.S. Patent Nos. 4,596,757; 4,650,738; 4,808,508; 4,929,532; 4,937,168; and EP 294,665 and EP 403,128 patent applications.

## Detailed Description of the Invention

The present invention provides a photosensitive color proofing element which comprises a carrier having coated thereon a photosensitive color coating comprising: i) a photopolymerizable oligomer comprising an alkyl vinyl- or aryl vinyl- maleic anhydride partial-ester copolymer having a plurality of pendant ethylenically unsaturated groups, an acid number of 100 to 250 and a number average molecular weight of 1,000 to 20,000, ii) a photopolymerizable compound having a plurality of pendant ethylenically unsaturated polymerizable groups and a weight average molecular weight of 400 to 1,500, iii) a colorant, and iv) a photoinitiator. Each of the colored elements are exposed to actinic radiation through a corresponding color separation film to produce a latent image. The latent image is formed by imagewise crosslinking of the exposed photosensitive color coating. When the imaged element is developed with an aqueous alkali developer, the un-exposed areas of the photosensitive coating is removed and the cross-linked image remains on the carrier. The imaged elements are then overlaid upon each other in register to form a composite multi-colored proof which may be mounted on any receptor.

In the preferred embodiment, the carrier is a dimensionally and chemically stable plastic sheet, more preferably a 2.0 to 3.0 mil (5.1 to 7.6 cm) polyester film. To assist in the handling of the films, it may be desirable to include an antistatic coating, such as the antistatic coating comprising a colloidal silica crosslinked with an ambifunctional silane coupling agent described in U.S. Patent No. 5,344,751. In addition, an anti-reflection coating(s), such as those described in U.S. Patent Nos. 4,340,276; 4,634,652; and 4,748,101, may also be included in the construction to reduce the interference patterns when viewing the composite proof.

The overlay construction may optionally include a protective topcoat applied over the photosensitive color coating. In the present invention, the topcoat need not be an oxygen barrier. It may be advantageous, however, to provide an additional coating to impart other desirable properties. For example, this optional topcoat may contain particulates, such as polymeric beads or silica to assist in vacuum draw-down in the exposure frame and improve handling properties, or anti-halation materials to improve resolution, or UV absorbers to balance exposure times of the various colors. The optional topcoat must be capable of being removed during development of the image. Preferred topcoats include water soluble resins, such as alkyl ethers of cellulose, polyvinyl alcohols and polyvinyl pyrrolidone.

Another embodiment of the present invention provides a negative acting single sheet color proofing element comprising in order: a) a carrier having a release surface; b) a photosensitive color coating comprising i) a photopolymerizable oligomer comprising an alkyl vinyl- or aryl vinyl- maleic anhydride partial-ester copolymer having a plurality of pendant ethylenically unsaturated groups and an acid number of 100 to 250 and a number average molecular weight of 1,000 to 20,000, ii) a photopolymerizable compound having a plurality of pendant ethylenically unsaturated polymerizable groups and a weight average molecular weight of 400 to 1,500, iii) a colorant, and iv) a photoinitiator; c) a photopolymerizable barrier coating; and d) a thermally activated adhesive.

The carrier sheet is provided with a release surface which may either be a smooth surface of the carrier itself or a surface release layer thereon. The function of the release surface is to serve as a parting layer between the carrier sheet and the photosensitive color coating layer. The preferred material for use in the present invention is a 1.5 to 2.0 mil (3.7 to 5.6 cm) polyester film provided with a release layer comprising a cellulose methyl ether, polyvinylpyrolidone or polyvinyl alcohol resin. The release properties of the release layer may be adjusted by the addition of surfactants. Preferred surfactants include alkylarylpolyether alcohols, such as Triton™ X-100 (octylphenoxy ethanol, available from Rohm & Haas, Philadelphia, PA), glycerin and ethoxylated castor oil. In the preferred embodiment, the surfactant is present in the release layer at about 0.1 to 5% by weight of solids in the layer, more preferably 0.5 to 2%. Other ingredients may be added such as mold inhibitors, anti-halation dyes, filter dyes, solvents, wetting agents, etc. Additionally, the carrier may have a smooth or textured surface and may also include colorants or UV absorbers.

A photosensitive color layer is coated onto the releasable surface of the carrier. This layer typically comprises a photopolymerizable oligomer based on an alkyl vinyl- or aryl vinyl- maleic anhydride partial-ester copolymer having a plurality of pendant ethylenically unsaturated groups, an optional photopolymerizable compound having a plurality of pendant ethylenically unsaturated groups, an optional acidic binder, a colorant and a photoinitiator system. The formulation is balanced such that highlight halftone dots are retained at short exposure times while maintaining a clean background in the non-imaged areas.

The addition of a photopolymerizable oligomer based on an alkyl vinyl- or aryl vinyl- maleic anhydride partial-ester copolymer having pendant ethylenically unsaturated groups has a significant effect on both dot retention and background clean-out. The acid functionality of the oligomer assists in providing better adhesion of the imaged or cured photosensitive color layer in combination with the underlying adhesive layer with or without the photopolymerizable barrier. The molecular weight and acid functionality of the oligomer also play a significant role in the solubility of the cured and uncured portions of the photosensitive color layer. If the molecular weight is too low and/or the acid functionality too high, then the imaged or cured portion of the photosensitive layer may be attacked by the developer resulting in density loss, uneven development around the fringes of the halftone dots, or complete loss of the highlight dots. On the other had, if the molecular weight is too high and/or the acid functionality too low, then the non-imaged portions of the photosensitive layer may not be removed by the developer, resulting in loss of resolution in the shadow areas of the proof (90-99.5% dots) or background staining. The strength of the developer can be increased in this particular situation to assist in the removal of the layer; however, this may lead to loss of the highlight dots. It is well know in the art that if the alkyl vinyl-maleic anhydride copolymers are used as compared to the aryl vinyl-maleic anhydride copolymers, then a higher molecular weight material may be desired. Suitable acrylated or methacrylated alkyl vinyl- or aryl vinyl- maleic anhydride partial-ester copolymers have an acid number between about 100 and 250 and a number average molecular weight of at least 1,000, preferably between 1,000 and 20,000, more preferably between 1,000 and 10,000 and most preferably between 1,000 and 5,000. Examples of commercially available materials from Sartomer Co. Inc., Exton, PA include Sarbox™ 401 (methacrylated styrene/maleic partial-ester copolymer having an acid number of $145 \pm 15$ and a number average molecular weight of 2,500) and PRO™ 884 (acrylated styrene/maleic anhydride partial-ester copolymer having an acid number of about 200 and a number average molecular weight of 2,000). These materials are generally described in U.S. Patent Nos. 4,745,138 and 4,722,947 and have the following general formula:

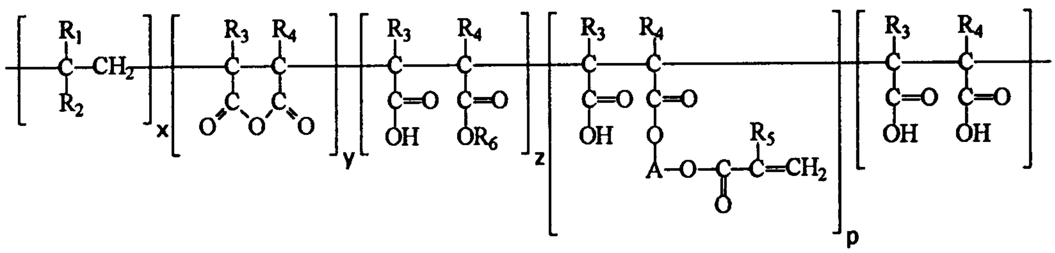

wherein:

$R_1$ and $R_2$ are selected from the group consisting essentially of hydrogen, alkyl containing from 1 to 20 carbon atoms, aryl containing from 6 to 10 carbons atoms, alkaryl containing from 7 to 14 carbon atoms, cycloalkyl containing from 4 to 12, preferably 4 to 6 carbon atoms, and halogen such as chlorine, fluorine or bromine. $R_1$ and $R_2$ may be the same or different and preferably are each independently hydrogen, methyl, phenyl, benzyl, or cycloalkyl of 4 to 6 carbon atoms.

The groups $R_3$, $R_4$ and $R_5$ are the same or different groups and are selected from the group consisting of hydrogen and alkyl of from 1 to 5 carbon atoms, and preferably are each independently hydrogen and/or methyl.

The group $R_6$ is the same or different group selected from the group consisting of hydrogen, alkyl, aralkyl, and alkyl substituted aralkyl groups containing from 1 to 20 carbon atoms, and oxyalkylated derivatives of such groups containing from 2 to 4 carbon atoms in each oxyalkylene group, which group may be from 1 to 20 repeating units, preferably 1 to 6 repeating units; and the group A is a linear or branched divalent alkylene of from 1 to 20 carbon atoms or an oxyalkylated derivative thereof as described in connection with $R_6$.

Subscripts x, y, z, m and p are each whole numbers such that the sum of x, y, z, m and p may range from 3 to about 20; x, p and y are each equal to or greater than 1; and z and/or m may be O; preferably x is equal to 3 to 20, as well as to the sum of y, z, m and p. The copolymer has an acrylate equivalent per gram value of at least 0.1, preferably between 1 and 2.

In the present invention, a preferred copolymer is when $R_1$ is a hydrogen and $R_2$ is a phenyl group. Unlike most other acrylated or methacrylated oligomers, the Sarbox™ 401 and PRO™ 884 may be formulated with a pigment millbase and photoinitiator to afford a non-tacky photosensitive color layer. The reduction in tack provides easier manufacturing of the elements. Tacky coatings have a tendency to pick-up dirt or the color coating transfers to face-side rollers in the coating and drying process during the manufacturing of the proofing elements.

The photosensitive color layer may also include non-acidic materials to adjust the developability of the layer depending upon the strength of the developer. It is sometimes advantageous to increase the strength of the developer slightly to formulate a more robust film. This will provide more latitude when the proofing elements are subjected to the mechanical action of brushes or developing pads in an automated processing apparatus. The preferred materials for adjusting developability include photopolymerizable compounds having a plurality of pendant ethylenically unsaturated polymerizable groups, such as photopolymerizable polymers, oligomers or monomers having a weight average molecular weight of about 400 to 1,500 and at least 2 pendant ethylenically unsaturated polymerizable groups, more preferably at least 4 pendant ethylenically unsaturated polymerizable groups. Examples of suitable ethylenically unsaturated polymerizable groups include acryloyl, methacryloyl and acrylamido groups. Suitable polymers, oligomers or monomers are well known in the art and non-exclusively include materials such as novolac acrylate resins (i.e., Echo™ 310, available from Echo Resins and Laboratory, Versailles, MO), acrylate or methacrylate esters of polyols, (i.e., polybutane diol diacrylate, dipentaerythritol pentaacrylate, pentaerythritol tetraacrylate and triacrylate, pentaerythritol tetramethacrylate and trimethacrylate, hydantoin hexaacrylate, and tetrahydrofurfurylmethacrylate), acrylated or methacrylated urethane oligomers (i.e., Ebecryl™220, hexaacrylate urethane oligomer, available from UCB Radcure Inc., Louisville, KY), and acrylamides (i.e., diacetone acrylamide and acrylamidoethyl methacrylate). The composition of the polymer, oligomer or monomer backbone is not critical as long as it does not impart visible color shifts (less than 1 delta E measured spectrophotometrically with a Gretag SPM spectrophotometer) in the photosensitive color layer during the imaging process or upon natural aging (90 days at ambient temperature). A preferred photopolymerizable compound has no acid functional groups or weakly acidic groups, such as phenolic groups.

A balance is maintained between the acid functionality, the polymerizable functionality and the strength of the developing medium to optimize the resolution and latitude of the final imaged proofing element. The best resolution is achieved when an aqueous developer is used having a pH of about 10 to 11, preferably 10 to 10.5 and the acid number of the photosensitive layer is adjusted to about 30 to 75, more preferred 40 to 60 and most preferred 45 to 55. The preferred weight percentage of polymerizable materials present in the photosensitive layer is 20 to 80% and most preferred is 40 to 60%.

In the preferred embodiment, the photoinitiator(s) used must not generate a visible color change in the image or adhesive layers after exposure. Examples of photoinitiators non-exclusively include; triazines, acetophenones, benzophenones, and thioxanthones. The preferred photoinitiators include Irgacure™ 907(2-methyl-1-(4-(methylthio)phenyl)-2-(4-morpholinyl)-1-propane) available from Ciba Geigy Corp., Hawthorne, NY), Irgacure™ 369 (2-benzyl-2-(dimethylamine)-1-4-(r-morpholinylphenyl)-1-butanone, available from Ciba Geigy Corp., Hawthorne, NY), Speedcure™ ITX (isopropylthioxanthone, available from Aceto Chemical Co. Inc., Flushing, NY) and triazines tethered to alkylarylpolyether alcohols as described in U.S. Patent No. 5,298,361. The initiators may be used singly or in combination with each other. The optimum amount of initiator will be dependent upon the oligomer type used and the filtering effect of the pigment used; however, the initiator is usually present in concentrations of about 1.0 - 15% by weight of the photosensitive composition.

Pigments or dyes may be used as colorants in the photosensitive color layer. However, pigments or polymeric dyes are preferred since they have a lower tendency for migration between the layers. Pigments are more preferred due to the wide variety of colors available and lower cost. Pigments are generally introduced into the photosensitive formulation in the form of a millbase comprising the pigment dispersed with a binder and suspended into a solvent or mixture of solvents. The dispersion process may be accomplished by a variety of methods well known in the art, such as two-roll milling, three-roll milling, sand milling, ball milling, etc. Many different pigments are available and are well known in the art. The pigment type and color are chosen such that the coated color proofing element is matched to a preset color target or specification set by the industry. Color enhancing additives may be used which include fluorescent, pearlescent, iridescent, and metallic materials. Materials such as silica, polymeric beads, reflective and non-reflective glass beads, or mica may also be added in place of a colorant to provide a textured image. The color enhancing additives or texturing materials may be used either alone or in combination with the above pigments to produce proofs with the desired visual effects.

The type of dispersing resin and the pigment to resin composition ratio chosen are dependent upon the pigment type, surface treatment on the pigment, dispersing solvent and milling process. Some examples of resins suitable for generating millbases which are compatible with the aforementioned photo-oligomers and monomers include; polyvinyl acetate/crotonic acid copolymers, styrene/maleic anhydride partial-ester resins, acid containing acrylic and methacrylic polymers and copolymers, polyvinyl acetals, polyvinyl acetals modified with anhydrides and amines, hydroxy alkyl cellulose resins and styrene/acrylic/acrylic acid resins. The dispersion may contain a mixture of these resins. The pigment to resin ratio in the dispersion is typically between 0.6 to 5.0, preferably between 0.8 to 3.0.

A dispersing agent may be necessary to achieve optimum dispersion quality. Some examples of dispersing agents include; polyester/polyamine copolymers, alkylarylpolyether alcohols, acrylic resins and Disperbyk™ wetting agents available from Byk-Chemie USA, Wallingford, CT. Other components may also be included in the millbase such as surfactants to improve solution stability, fluorescent materials, optical brighteners, UV absorbers, fillers, etc.

The preferred composition of the millbase solids comprises about 30 - 71% by weight pigment, 15-30% by weight acidic resin, 0-25% non-acidic resin, and 0-20%, more preferably 0-10% by weight dispersing agents. Additional binders may also be included in the photosensitive color formulation to balance developability and tack for each color. The coating weights of the individual colors may vary in order to achieve the preset color target. The color formulations are adjusted to achieve optimum color, resolution, exposure speed and developability. Typical dry color coating weights are between 50 $mg/ft^2$ and 150 $mg/ft^2$ (0.54 $g/m^2$ and 1.61 $g/m^2$), preferred 60 $mg/ft^2$ and 90 $mg/ft^2$ (0.65 $g/m^2$ and 0.97 $g/m^2$).

Coated adjacent to the photosensitive color layer is the photopolymerizable barrier layer. The photopolymerizable barrier layer is present to prevent interaction between the color layer and the adhesive, and also improves developability of the non-image areas. The barrier layer typically comprises an photopolymerizable ethylenically unsaturated compound, an acidic binder and a photoinitiator. Preferred examples of ethylenically unsaturated compounds include acrylated epoxy oligomers, acrylated urethane oligomers as described in U.S. Patent No. 4,304,923, Echo™ TAE 310 (triacrylated aromatic epoxide available from Echo Resins and Laboratory, Versailles, MO) and Dynacoll™ A 6083 (acrylated copolyester available from Huls America, Piscataway, NJ). The ethylenically unsaturated compound is present at about 50-65% by weight of the total barrier composition. Preferred binders include; polyvinyl acetate/crotonic acid copolymers, styrene/maleic anhydride partial-ester resins, acid containing acrylic and methacrylic polymers and copolymers, acidified polyvinyl acetals, and styrene/acrylic/acrylic acid resins. The acidic binder or resin is present at about 30-50% by weight of the total barrier composition. Preferred photoinitiators include; Irgacure™ 907, Speedcure™ ITX and triazines tethered to alkylarylpolyether alcohols. The initiator is present at 0-10% by weight of the total barrier composition. The addition of photoinitiator may be unnecessary depending upon the extent upon which the barrier layer intermixes with the adjacent photosensitive color layer. The barrier layer is coated to a dry coating weight of about 0.15 to 2.0 $g/m^2$, preferably about 0.2 to 1.0 $g/m^2$.

In the preferred embodiment, the barrier layer coating is applied and dried such that the photosensitive color layer and barrier layer become intermixed. The solvent interacts with the photosensitive color layer so that mixing at the interface may occur, but does not penetrate, swell or dissolve the photosensitive color layer to the extent that it destroys the uniformity of the color layer or interferes with the releaseablilty of the coatings from the carrier. The photosensitive color layer and barrier may intermix to the extent that the layers are indistinguishable by SEM (scanning electron microscope). In other words, the layers for all practical purposes perform as one layer instead of two distinct layers and there is no observable absolute and sharp separation of materials at the interface between the two layers. Suitable solvents include ketones, ethers, alcohols, chlorinated alkanes, aromatics and esters (i.e., methyl ethyl ketone, methyl isobutyl ketone, trichloroethylene, propanol, ethyl acetate, tetrahydrofuran, propylene glycol monomethyl ether and toluene).

Coated adjacent to the photopolymerizable barrier layer is the adhesive layer. The adhesive layer provides a means of laminating the color proofing element to a temporary or permanent substrate under heat and pressure. The solvent used for this coating must not attack or interact with the coatings present on the carrier. Examples of solvents include alcohols, water and hydrocarbon solvents. Because hydrocarbon solvents like heptane and naphtha are prone to irregular coating patterns, due primarily to static, more polar solvents such as water and alcohols are preferred. The adhesive is preferably a thermally activated adhesive that is softenable at a temperature of less than 200°C,. preferably within a range between 100°C and 160°C. In contrast with the softening characteristics of the adhesive it is desirable that the adhesive not block during storage or shipment. Resins having a Tg between 45°C and 60°C, including copolymers and terpolymers of alkyl acrylate, alkyl methacrylate, styryl, and acrylamide monomers, meet both the lamination criteria and avoid the potential for blocking, without requiring the use of an additional protective liner. Useful resins include polymers, copolymers and terpolymers of methyl methacrylate, n-butyl methacrylate, n-butyl/isobutyl methacrylate, vinylacetates, N-(hydroxymethyl) acrylamide and styrenes. Vinyl acetate polymers have been found to be very sensitive to moisture and can cause blocking of the coated materials in shipment and storage if the vinyl acetate component of the adhesive is present in amounts greater than 20%. Other additives may be present to aid in coating and performance such as surfactants, coalescent aids, plasticizers, slip agents (i.e., polymethacrylate beads like those described in U.S. Patent No. 4,885,225, silica, polyethylene waxes), optical brighteners, UV absorbers, etc.

A multi-colored proof is made by laminating a color proofing element onto a receptor. The carrier may be removed either prior to exposure or prior to the development step. The laminated structure is imaged through a negative color separation graphic art film corresponding to the color of the proofing element to create a latent image. The spectral and power output of the exposure unit and the absorption of the photoinitiator system are chosen for an optimum exposure speed. Typical exposure units are equipped with UV lamps having optimum spectral outputs between 250 nm and 500 nm and a power output between 2.5 and 10 Kilowatts. The exposed laminated structure is then developed with an aqueous alkali developer. The process of laminating, exposing and developing is then repeated using a different color until the desired multi-colored composite proof is complete. A non-colored or textured image may be added if so desired by laminating, exposing and developing a proofing element whose photosensitive layer contains texturing materials such as those described earlier in place of or in addition to a colorant.

The receptor may be a permanent substrate. A suitable composition for the receptor sheet is a heat stable, waterproof white paper, such as P-350 (available from Schoeller Technical Paper Sales, Inc. of Pulaski, NY) or Matchprint™ base (available from 3M, St. Paul, MN). The receptor sheet may also be a polyester film or any other heat stable plastic material. Alternatively, the receptor may be a temporary receptor such as those described in U.S. Patent Nos. 5,240,810; 5,192,630; and 5,094,931.

Developer solutions used to develop the image after exposure are typically comprised of a combination of Sodium or Potassium carbonate, and Sodium or Potassium bicarbonate and a surfactant. In the preferred embodiment, the carbonate is present at about 0.5 - 2.0% by weight, the bicarbonate is present at about 0 - 1.0% by weight, and the surfactant is present at about 0.1 - 1.0% by weight of the total aqueous developer solution. The preferred surfactants non-exclusively include; Surfynol™ 465 (ethoxylated tetramethyl decynediol, available from Air Products and Chemicals, Allentown, PA), Surfactol™ 365 (ethoxylated castor oil, available from CasChem Inc., Bayonne, NJ), Triton™ X-100 (octylphenoxypolyethoxyethanol, available from Rohm and Haas, Philadelphia, PA), and Surfynol™ GA (acetylenic diols compounded with other non-ionic surfactants and solvents, available from Air Products and Chemicals, Allentown, PA).

The invention will now be illustrated in the following non-limiting examples:

## EXAMPLES

Unless designated otherwise, all materials are available from Aldrich Chemicals, Milwaukee, WI.

### Preparations

The following preparations describe methods for preparing materials used in the examples that are not commercially available.

Preparation of Acidified Butvar™ B-98

A 2 liter 3-necked roundbottom flask equipped with an overhead stirrer was charged with 300 g of Butvar™ B-98 (available from Monsanto Co., St. Louis, MO), 90 g of succinic anhydride, 90 g of triethylamine and 900 g of methyl ethyl ketone. The mixture was heated at 77°C for six hours. The solvent was removed under vacuum yielding a white solid. An Infrared spectrum of the material showed no anhydride peaks.

Preparation of Tethered m-MOST-ol photoinitiator

A stirred solution of 103 g of 2,4-bis(trichloromethyl)-1,3,5-triazine, 47 g of 3-(2-hydroxyethoxy)benzaldehyde), and 10.5 g of ammonium acetate in 270 mL of methanol was refluxed for 12 hours. Alter the mixture had cooled, an additional 80 mL of methanol was added, followed by 112 mL of water. The resultant precipitate was filtered and dried to yield 74 g of 2,4-bis(trichloromethyl)-6-[3-(2-hydroxyethoxy)styryl]-1,3,5-triazine (herein afier refered to as "m-MOST-ol").

To a stirred dispersion containing 55.00 g of m-MOST-ol and 18.2 g of 2,4-tolylene diisocyanate (herein after refered to as "TDI") in 200 mL of toluene at 16°C was added 0.150 g of dibutyltin dilaurate. A slight exotherm raised the temperature of the reaction mixture to 19°C and the reaction mixture became clear after approximately 20 minutes. The m-MOST-ol had completely reacted in 5 hours and the resulting mixture of m-MOST-ol/TDI, $(\text{m-MOST-ol})_2$/TDI and residual 2,4-tolylene diisocyanate. To this mixture was added 58.92 g of a 79.2% solution of polyoxyethylene nonylphenol (Igepal™ CO-520) in toluene and the solution was heated to 60°C and maintained at that temperature for 4 hours. Removal of the toluene under vacuum by means of a rotary evaporator provided a slightly brown viscous syrup. The material was redissolved in sufficient methyl ethyl ketone to produce a solution having a concentration of approximately 50% total solids.

Acrylated Urethane Oligomer P-11 (as described in U.S. Patent No. 4,304,923)

Polycaprolactone hexol was prepared by adding 63.5 g dipentaerythritol, 228 g of epsilon-caprolactone, and 0.02 g of 2,6-di-t-butyl-4-methylphenol to a 500 mL, three-neck flask equipped with an overhead mechanical stirrer and a condenser. The liquid was deoxygenated for 20 minutes by bubbling with dry nitrogen from a gas dispersion tub. This tube was then replaced with a gas inlet adapter and the reaction mixture heated while maintaining a slight positive pressure with nitrogen. The mixture was maintained at 170°C for 5 hours under continual stirring. The reaction mixture was then allowed to cool to room temperature under nitrogen atmosphere.

A 1 liter three-neck flask was fitted with an adapter, mechanical stirrer, thermometer, addition funnel and drying tube. To this flask was charged 175 g of the polycaprolactone hexol and 60 mL of methyl ethyl ketone. A solution of 13 g of 2,4-tolylene diisocyanate in 9 mL of methyl ethyl ketone was slowly dripped into the first solution with stirring at room temperature. The addition was completed in 20 minutes and the reaction mixture stirred for 90 minutes at 30°C.

To a second flask fitted with an overhead mechanical stirrer, thermometer, addition funnel and drying tube was charged 86.1 g of 2,4-tolylene diisocyanate. Through the addition funnel was added 70.2 g of 2-hydroxyethylmethacrylate (herein after refered to as "HEMA") and 0.02 g of 2,6-di-t-butyl-4-methylphenol (herein after refered to as "inhibitor") slowly with stirring to the diisocyanate while maintained below or at 30°C. The addition was completed in 15 minutes and after 40 minutes of reaction time, a white solid formed. The solid was dissolved in 45 mL of methyl ethyl ketone by heating to 45°C and held at that temperature for 10 minutes to complete the reaction.

The flask containing the reaction product of the polycaprolactone hexol and the 2,4-tolylene diisocyanate was heated to 67°C and the solution of the HEMA/2,4-tolylene diisocyanate adduct in methyl ethyl ketone was added slowly with stirring over a period of 2 hours. 27 g of succinic anhydride was then added with an additional 0.02 g of the inhibitor. Heating and stirring was continued until the anhydride had completely reacted (about 5-6 hours).

## Standard Millbases and Coating Solutions

The following standard millbases and coating solutions were used in the Examples.

| Release Layer Coating Solution: | |
|---|---|
| Airvol™ 205 Polyvinyl alcohol (available from Air Products and Chemicals, Allentown, PA) | 5.6 g |
| Airvol™ 107 Polyvinyl alcohol (available from Air Products and Chemicals, Allentown, PA) | 2.4 g |
| Triton™ X-100 (octylphenoxypolyethoxyethanol, available from Rohm and Haas, Philadelphia, PA) | 0.2 g |
| Kathon™ CG/ICP Preservative (available from Rohm and Haas, Philadelphia, PA) | 0.09 g |
| Deionized Water | 91.7 g |

| Millbases: | | | | | |
|---|---|---|---|---|---|
| **Ingredients** | **Red Shade Magenta** | **Blue Shade Magenta** | **Black** | **Green Shade Cyan** | **Red Shade Cyan** |
| Sun 234-0077 Red Shade Magenta (available from Sun Chemical, Cincinnati, OH) | 8.4 g | | | | |
| C-G RT-333D Blue Shade Magenta (available from Ciba-Geigy, Newport, DE) | | 8.47 g | | | |
| Raven 760 (available from Columbian Chemicals Co., Tulsa, OK) | | | 8.3 g | | |
| Sun 249-0592 Green Shade Cyan (available from Sun Chemical, Cincinnati, OH) | | | | 8.72 g | |
| Sun 248-0615 Red Shade Cyan (available from Sun Chemical, Cincinnati, OH) | | | | | 8.72 g |
| Acidified Butvar™ B-98 | 1.12 g | 2.82 g | 1.483 g | 2.9 g | 2.9 g |
| Joncryl™ 67 (styrene/acrylic resin available from S.C. Johnson Wax, Racine WI) | 4.48 g | 2.82 g | 4.43 g | 2.9 g | 2.9 g |
| Disperbyk™ 161 (available from Byk-Chemie USA, Wallingford, CT) | 0.84 g | 0.85 g | 0.75 g | 0.436 g | 0.436 g |
| FC-430 (fluorchemical surfactant, available from 3M, St. Paul, MN) | 0.168 g | 0.0045 g | 0.033 g | 0.03 g | 0.03 g |
| Methyl ethyl ketone | 59.5 g | 59.5 g | 59.5 g | 59.5 g | 59.5 g |
| Propyleneglycol monomethyl ether | 25.5 g | 25.5 g | 25.5 g | 25.5 g | 25.5 g |

| Photopolymerizable Barrier Layer Coating Solution | |
|---|---|
| Echo™ 310 (novolac diacrylate resin, available from Echo Resins and Laboratory, Versailles, MO) | 2.9 g |
| Joncryl™ 586 (styrene/acrylic resin, available from S.C. Johnson Wax, Racine, WI) | 2.0 g |
| Tethered m-MOST-ol photoinitiator | 0.1 g |
| Methyl ethyl ketone | 95.0 g |

| Thermally Activated Adhesive Coating Solution | |
|---|---|
| Synthemul™ R-97603 (terpolymer of N-(hydroxymethyl) acrylamide/butyl acrylate/methyl methacrylate, available from Reichhold Chemicals Inc., Dover, DE) | 77.6 g |
| Deionized Water | 22.2 g |
| 8 Micron Polymethyl methacrylate beads (prepared as described in U.S. Patent No. 2,701,245) | 0.2 g |

**Example 1**

The following photosensitive magenta and cyan color solutions were prepared to illustrate the effect of using a acrylated styrene/maleic anhydride partial-ester in combination with a multi-functional acrylated monomer and acrylated novolac resin as the primary photopolymerizable materials in the photosensitive color layer of a color proofing element.

| **Ingredients** | **Magenta Coating Solution** | **Cyan Coating Solution** |
|---|---|---|
| Red Shade Magenta Millbase | 16.31 g | |
| Blue shade Magenta Millbase | 3.94 g | |
| Green Shade Cyan Millbase | | 11.9 g |
| Red Shade Cyan Millbase | | 3.94 g |
| Black Millbase | 0.66 g | 0.34 g |
| Sarbox™ 401 (methacrylated styrene/maleic anhydride partial-ester with a MW of 2,500, available from Sartomer Co. Inc., Exton, PA) | 31.08 g | 31.48 g |
| SR-399 (dipentaerythritol pentaacrylate with a MW of 525, available from Sartomer Co. Inc., Exton, PA) | 16.85 g | 17.06 g |
| Echo™ 310 (novolac diacrylate resin, available from Echo Resins and Laboratory, Versailles, MO) | 10.17 g | 10.0 g |
| Acidified Butvar B-98 | 10.0 g | 10.0 g |
| Tethered m-MOST-ol photoinitiator | 10.0 g | 10.0 g |
| Perenol™ F-40 (monoacrylate surfactant available from Henkel Corp., Ambler, PA) | 1.0 g | 1.0 g |
| Methyl ethyl ketone | 560 g | 536 g |
| Propylene glycol monomethyl ether | 240 g | 230 g |

**Example 2**

The following photosensitive magenta and cyan color solutions were prepared to further illustrate the effect of using a acrylated styrene/maleic anhydride partial-ester in combination with a multi-acrylate urethane oligomer and an acrylated novolac resin as the primary photopolymerizable materials in the photosensitive color layer of a color proofing element.

| Ingredients | Magenta Coating Solution | Cyan Coating Solution |
|---|---|---|
| Red Shade Magenta Millbase | 16.31 g | |
| Blue shade Magenta Millbase | 3.94 g | |
| Green Shade Cyan Millbase | | 11.9 g |
| Red Shade Cyan Millbase | | 2.94 g |
| Black Millbase | 0.66 g | 0.34 g |
| Sarbox™ 401 (methacrylated styrene/maleic anhydride partial-ester with a MW of 2,500, available from Sartomer Co. Inc. Exton, PA) | 31.08 g | 31.48 g |
| Ebecryl™ 220 (hexaacrylate urethane oligomer with a MW of 1,000, available from UCB Radcure Inc., Louisville, KY) | 16.85 g | 17.06 g |
| Echo™ 310 (novolac diacrylate resin, available from Echo Resins and Laboratory, Versailles, MO) | 10.17 g | 10.0 g |
| Acidified Butvar B-98 | 10.0 g | 10.0 g |
| Tethered m-MOST-ol photoinitiator | 10.0 g | 10.0 g |
| Perenol™ F-40 (monoacrylate surfactant, available from Henkel Corp, Ambler, PA) | 1.0 g | 1.0 g |
| Methyl ethyl ketone | 560 g | 536 g |
| Propylene glycol monomethyl ether | 240 g | 230 g |

**Example 3**

The following photosensitive magenta and cyan color solutions were prepared as comparative examples without the addition of the methacrylated styrene/maleic anhydride partial-ester copolymer.

| Ingredients | Magenta Coating Solution | Cyan Coating Solution |
|---|---|---|
| Red Shade Magenta Millbase | 16.76 g | |
| Blue shade Magenta Millbase | 3.24 g | |
| Green Shade Cyan Millbase | | 10.6 g |
| Red Shade Cyan Millbase | | 7.04 g |
| Black Millbase | 0.96 g | 0.41 g |
| Acrylated urethane oligomer P-11 (described in U.S. Patent No. 4,304,923) | 57.46 g | 51.03 g |
| Echo™ 310 (novolac diacrylate resin, available from Echo Resins and Laboratory, Versailles, MO) | | 8.98 g |
| Joncryl™ 67 (styrene/acrylic acid resin, available from Johnson Wax, Racine, WI) | 8.15 g | 12.16 g |
| Acidified Butvar B-98 | 8.5 g | 5.04 g |
| Tethered m-MOST-ol photoinitiator | 5.0 g | 4.74 g |
| FC-430 (fluorinated surfactant, available from 3M, St. Paul, MN) | 0.19 g | 0.04 g |
| Methyl ethyl ketone | 560 g | 560 g |
| Propylene glycol monomethyl ether | 240 g | 240 g |

The magenta photosensitive color solutions in the Examples 1 and 3 were incorporated into a color proofing element prepared in the following manner.

The release layer was coated and dried on a 2 mil (0.51 mm) polyester substrate to achieve a dry coating weight of about 1 $g/m^2$. Each of the photosensitive color layers solutions were then coated and dried on the release layer at a target density. The photopolymerizable barrier solution was then applied at a dry coating weight of approximately 32 $mg/ft^2$ (0.34 $g/m^2$) followed by the adhesive solution at a dry coating weight of approximately 650 $mg/ft^2$ (7.0 $g/m^2$).

Each of the proofing elements using the magenta photosensitive color solutions in Examples 1 and 3 were laminated to a Matchprint™ paper base (available from 3M, St. Paul, MN) and exposed through a UGRA plate control target (available from EMPA/UGRA, St. Gallen, Switzerland) and a Control Target generated on a Crossfield scanner. The UGRA plate control target represents a hard dot film (i.e., a contact film) and the Crossfield element represents a soft dot film (i.e., a scanner film). The materials were exposed with a UV light source having a power output of 0.15 $Watt/cm^2$. The imaged materials were developed using a developer comprising 1% potassium carbonate, 1% potassium bicarbonate and 0.1% Surfynol™ 465 (ethoxylated tetramethyldecynediol surfactant, available from Air Products) in water.

The exposure latitude is measured by exposing the color proofing element through UGRA or Crossfield control elements using several different exposure times or units. The control targets contain both a grey scale in 0.15 increments and halftone dots ranging from 0.5% to 99.5% dots. The color proofing image is then evaluated for its ability to retain the highlight dots and keep open the shadow dots. The number of grey scale steps are visually counted where both the 2% highlight dots are retained and the 98% shadow dots are kept open. The grey scale step held is an indication of the sensitivity of the photosensitive layer. Holding of a grey scale step is defined as the highest numbered step on a grey scale having a visual density nearly equivalent to the maximum density of the photosensitive color layer. The latitude can be mathematically calculated from the following equation;

$$Latitude = (\log(E2) - \log(E1)) / 0.15$$

where, E1 is equal to the minimum exposure time or units required to produce the smallest visible highlight dot and E2 is the maximum exposure time or units before the closure or background staining of the shadow areas (98% dots). Table I summarizes the results observed.

Table I

| | Magenta Example 1 | Magenta Example 3 (Comparative) |
|---|---|---|
| Exposure Latitude UGRA 2-98% dots | 6 | 2.5 |
| Exposure Latitude Crossfield 2-98% dots | 4.5 | 0.5 |
| Exposure units required to hold 1% UGRA dots<br>Grey Scale | 8 Units<br>0.9 grey scale | 24 Units<br>4.9 grey scale |
| Exposure units required to hold 1% Crossfield dots<br>Grey Scale | 10 Units<br>1.9 grey scale | 28 Units<br>5 grey scale |

The exposure latitude of the magenta color proofing element produced with the photosensitive color solution containing the Sarbox™ 401 (methacrylated styrene/maleic anhydride partial-ester copolymer) is significantly better than the comparative Example 3 without the Sarbox™ 401. The reproduction of halftone dots was improved for both hard dot films and soft dot films. The exposure time required to hold the highlight dots has also significantly been reduced by the addition of the Sarbox™ 401 as compared to the comparative Example 3.

Each of the photosensitive color solutions in Example 1-3 were coated onto a Melinex™ 054 polyester film (available from ICI Americas Inc., Wilmington, DE). The magenta solutions were coated to a color density of 1.4. The cyan solutions were coated to a color density of 1.33. Color densities were measured using a Gretag SPM-100 spectrophotometer. No additional layer were used. The films were exposed with a UV light source under vacuum. After exposure, the photosensitive layer was developed using the same aqueous alkali developer as described earlier. Table 2 summarizes the results observed.

Table 2

| Sample | Grey Scale Steps | Exposure Units | Smallest UGRA dot retained | Smallest Crossfield dot retained |
|---|---|---|---|---|
| Magenta Example 1 | 5.5 | 28 | 0.5% | 1.0% |
| Magenta Example 2 | 5.0 | 28 | 0.5% | 1.0% |
| Magenta Example 3 (comparative) | 2.0 | 28 | 4.0% | 5.0% |
| Cyan Example 1 | 6.0 | 28 | 0.5% | 1.0% |
| Cyan Example 2 | 5.0 | 28 | 0.5% | 1.0% |
| Cyan Example 3 (comparative) | 2.0 | 28 | 4.0% | 5.0% |

In an overlay construction, the addition of the Sarbox™ 401 (methacrylated styrene/maleic anhydride partial-ester copolymer) had dramatic effects on the ability of the photosensitive film to retain highlight dots as compared to Example 3 without the Sarbox™ 401.

**Example 4**

The following example illustrates the resistance of the photosensitive color layer containing the Sarbox™ 401 material to oxygen inhibition.

The magenta photosensitive color solutions in the Examples 1 and 3 were incorporated into a color proofing element prepared in the following manner.

The release layer was coated and dried on a 2 mil (0.51 mm) polyester substrate to achieve a dry coating weight of about 1 $g/m^2$. Each of the photosensitive color layers solutions were then coated and dried on the release layer at a target density. The photopolymerizable barrier solution was then applied at a dry coating weight of approximately 32 $mg/ft^2$ (0.34 $g/m^2$) followed by the adhesive solution at a dry coating weight of approximately 650 $mg/ft^2$ (7.0 $g/m^2$).

Each of the proofing elements using the magenta photosensitive color solutions in Examples 1 and 3 were laminated to a Matchprint™ paper base. Part of the release layer was removed using a pressure sensitive tape on each of the laminated samples. The samples were then exposed without vacuum in a UV light source and developed using the alkali developer solution described earlier. Table 3 summarizes the results observed.

Table 3

| | Example 1 | Example 3 (comparative) |
|---|---|---|
| Release Layer present during exposure | 1.43 | 1.40 |
| Release Layer removed during exposure | 1.42 | 0.71 |

Polyvinyl alcohol resins are well known to act as oxygen barriers; therefore, the presence of the release layer acts as an oxygen barrier. The results in Table 3 clearly show that Example 1 containing the Sarbox™ 401 material is not sensitive to oxygen. By comparison, Example 3 without the Sarbox™ 401 material shows a significant drop in density due to inhibition of the polymerization by oxygen.

Reasonable variations and modifications are possible from the foregoing disclosure without departing from either the spirit or scope of the invention as claimed.

## Claims

**1.** A color proofing element comprising:

(a) a carrier; and
(b) a photosensitive color layer comprising;

(i) a photopolymerizable oligomer comprising an alkyl vinyl- or aryl vinyl- maleic anhydride partial-ester copolymer having a plurality of pendant ethylenically unsaturated groups, an acid number of 100 to 250 and a number average molecular weight of 1,000 to 20,000;
(ii) a colorant; and
(iii) a photoinitiator.

**2.** A negative acting color proofing element comprising, in order:

(a) a releasable carrier;
(b) a photosensitive color coating comprising;

(i) a photopolymerizable oligomer comprising an alkyl vinyl- or aryl vinyl- maleic anhydride partial-ester copolymer having a plurality of pendant ethylenically unsaturated groups, an acid number of 100 to 250 and a number average molecular weight of 1,000 to 20,000,
(ii) a colorant; and
(iii) a photoinitiator;

(c) a photopolymerizable barrier coating; and
(d) a thermally activated adhesive.

**3.** The color proofing element of Claim 2 wherein said photosensitive color coating and said photopolymerizable barrier coating are intermixed.

**4.** The color proofing element of Claim 2 wherein said photosensitive color coating further comprises a photopolymerizable compound having a plurality of pendant ethylenically unsaturated polymerizable groups and a weight average molecular weight of 400 to 1,500.

**5.** The color proofing element of Claim 4 wherein said pendant ethylenically unsaturated groups are selected from the group consisting of acryloyl, methacryloyl and acrylamido.

6. The color proofing element of Claim 2 wherein said photosensitive color coating further comprises a photopolymerizable novolac binder having at least one pendant acrylate group.

7. The color proofing element of Claim 2 wherein said colorant is replaced with a texturing material selected from the group consisting of silica, polymeric beads, glass beads, and mica.

8. A negative acting color proofing element comprising, in order:

(a) releasable carrier;
(b) a photosensitive color coating comprising:

(i) a photopolymerizable oligomer having the formula;

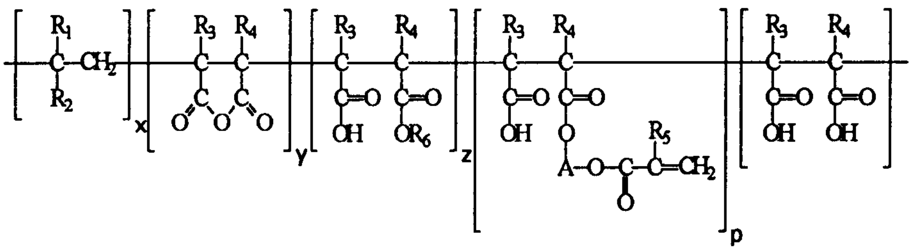

wherein:

$R_1$ and $R_2$ are the same or different groups and are selected from the group consisting essentially of hydrogen, alkyl containing from 1 to 20 carbon atoms, aryl containing from 6 to 10 carbons atoms, alkaryl containing from 7 to 14 carbon atoms, cycloalkyl containing from 4 to 12, and halogen;
$R_3$, $R_4$ and $R_5$ are the same or different groups and are selected from the group consisting of hydrogen and alkyl of from 1 to 5 carbon atoms;
$R_6$ is the same or different group selected from the group consisting of hydrogen, alkyl, aralkyl, and alkyl substituted aralkyl groups containing from 1 to 20 carbon atoms, and oxyalkylated derivatives of such groups containing from 2 to 4 carbon atoms in each oxyalkylene group, which group may be from 1 to 20 repeating units;
A is a linear or branched divalent alkylene of from 1 to 20 carbon atoms or an oxyalkylated derivative thereof as described in connection with $R_6$;
subscripts x, y, z, m and p are each whole numbers such that the sum of x, y, z, m and p may range from 3 to 20; x, p and y are each equal to or greater than 1; m may be O; and z maybe O;
said oligomer having an acid number of 100 to 250 and a number average molecular weight of 1,000 to 20,000;

(ii) a polymerizable compound having a plurality of pendant ethylenically unsaturated polymerizable groups and a weight average molecular weight of 400 to 1,500;
(iii) a colorant; and
(iv) a photoinitiator;

(c) a photopolymerizable barrier coating; and
(d) a thermally activated adhesive.

European Patent Office

# EUROPEAN SEARCH REPORT

Application Number
EP 96 10 4277

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-3 825 430 (K.A. KURKA) 23 July 1974<br>* examples 6,7 * | 1 | G03F3/10<br>G03F7/027<br>G03F7/033<br>G03F7/038 |
| X | US-A-5 296 334 (S.A. CASTALDI ET AL.) 22 March 1994<br>* example 1 * | 1 | |
| A,D | EP-A-0 529 789 (MINNESOTA MINING AND MANUFACTURING COMPANY) 3 March 1993<br>* page 13; claim 1 * | 1-8 | |
| A | EP-A-0 585 164 (MINNESOTA MINING AND MANUFACTURING COMPANY) 2 March 1994<br>* claims * | 1-8 | |
| A | FR-A-2 253 772 (LE QUADRIMETAL OFFSET) 4 July 1975<br>* claims * | 1 | |

TECHNICAL FIELDS SEARCHED (Int.Cl.6)

G03F

The present search report has been drawn up for all claims

| Place of search | Date of completion of the search | Examiner |
|---|---|---|
| THE HAGUE | 12 August 1996 | J.-M. DUPART |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)